# EUROPÄISCHE PATENTANMELDUNG

(11) **EP 0 779 526 A2**
(43) Veröffentlichungstag der Anmeldung: **18.06.1997**
(21) Anmeldenummer: 96119053.5
(22) Anmeldetag: 28.11.1996
(51) Int. Cl.: G02B 6/42, G02B 6/30, G02B 6/255, H01L 21/60

(54) **Optische und/oder elektrooptische Verbindung und Verfahren zur Herstellung einer solchen**

(30) Priorität: 13.12.1995 DE 19546443
(71) Anmelder: Deutsche Telekom AG, 53113 Bonn (DE); Ferdinand-Braun-Institut für Höchstfrequenztechnik im Forschungsverbund Berlin e. V., 12489 Berlin (DE)
(72) Erfinder: Richter, Hartwig, Dr.-Ing., 64291 Darmstadt (DE); Becker, Manfred, Dr.rer.nat., 10409 Berlin (DE)

(57) **Zusammenfassung**

Eine optische und/oder elektrooptische Verbindung von zwei optischen und/oder elektrooptischen Komponenten besteht aus Strukturen mit optischen Wellenleitern, die im Bereich der Verbindungsstelle parallel oder im wesentlichen parallel zur Auflagefläche auf einer Trägerplatte angeordnet sind. Die beiden Komponenten sind ohne Verwendung von Hilfsträgern unmittelbar auf nur einer einzigen, gemeinsamen Trägerplatte durch Schweißen mit elektromagnetischer Strahlung im Wellenlängenbereich um 1 µm befestigt.

Durch die genannten Maßnahmen ist es gelungen, eine optische und elektrische Verbindung von elektrooptischen Komponenten zu schaffen, die kostengünstig realisierbar sowie langzeit- und temperaturstabil ist, um in wirtschaftlich vertretbarer Weise informationsübertragendes Licht aus einem oder mehreren Wellenleitern der einen Komponente in einen oder mehrere Wellenleiter der anderen Komponente einkoppeln zu können.

## Beschreibung

Die Erfindung bezieht sich auf eine optische und/oder elektrooptische Verbindung von zwei optischen und/oder elektrooptischen Komponenten, jeweils bestehend aus Strukturen mit optischen Wellenleitern, die im Bereich der Verbindungsstelle parallel oder im wesentlichen parallel zur Auflagefläche auf einer Trägerplatte angeordnet sind.

Zur Übertragung von Information für Anwendungen wie die optische Nachrichtentechnik oder für Sensoren ist der Wellenlängenbereich von 0,6 bis 1,6 µm wegen der niedrigen Dämpfung und der geringen Dispersion der Glasfaser sehr vorteilhaft. Das Verbinden der für diese Übertragung erforderlichen optischen und elektrooptischen Komponenten ist sehr kostenintensiv, insbesondere wenn die Wellenleiter der zu einem System zu verbindenden Komponenten einmodig sind. Oft müssen Fügetoleranzen im Mikrometer- und Submikrometerbereich bei großen Temperaturschwankungen über Jahrzehnte eingehalten werden. Wohl das kritischste Bauteil eines solchen Systems ist eine Anordnung zur Kopplung des Lichtes aus einem Halbleiterlaser-Sender in eine Einmodenfaser, weil her zwei Strahlen mit Fleckweiten kleiner als 1 µm zur Überlappung gebracht werden müssen. Da die Faser einen Fleck von etwa 5 µm hat, ist es vorteilhaft, bei einer Koppelanordnung die Fleckweiten von Laser und Faser einander anzupassen. Dies kann durch eine Linse zwischen Laser und Faser, eine auf das Faserende aufgebrachte Linse oder durch einen in den Laserchip integrierten Fleckweitentaper erfolgen.

Anordnungen aus Komponenten mit ähnlich kleinen Fleckweiten, wie z. B. Halbleiterlaser-Verstärker oder Transceiver, sind vergleichbar kritisch.

Geringfügig weniger kritisch ist das Verbinden von Komponenten mit an eine Glasfaser angepaßten Fleckweiten, wie z. B. Splitter, Modulatoren, Schalter, Wellenlängenmultiplexer und -Demultiplexer, weil auch hier die Fleckweiten mit 5 µm und damit die Fügetoleranzen noch sehr klein sind. Entsprechendes gilt für Anordnungen zur Kopplung zweier Fasern wie z. B. Spleiße oder Stecker.

Bisher eingesetzte Verbindungen der in Rede stehenden Art wiesen eine Reihe von Nachteilen auf. Die Befestigungselemente hatten eine komplizierte Struktur und waren voluminös und teuer. In den meisten Fällen mußte jede elektrooptische Komponente für sich auf einen Hilfsträger montiert werden. Hierzu waren zusätzliche Befestigungsverfahren, wie z. B. Löten des Lasers oder Kleben der Faser in ein Montageröhrchen notwendig (Kleber kann schrumpfen und im Alter spröde werden!). Diese Hilfsträger mußten dann auf dem Hauptträger montiert werden. Wegen der Addition der Montagefehler (z. B. unterschiedliche Dicke des Lotes zwischen Halbleiterlaser und Hilfsträger) waren die Anordnungen mechanisch ungenau, voluminös und damit temperaturempfindlich und außerdem wegen der langen Montagezeiten teuer.

Ein erster Ansatz zur Verbesserung von optischen und/oder elektrooptischen Verbindungen der in Rede stehenden Art läßt sich der DE-OS 41 40 283 entnehmen. Die aus dieser Druckschrift ersichtliche Verbindung erfordert aber immernoch eine komplizierte Trägerstruktur, und sie macht über die Befestigung der übrigen Komponenten keine Aussage.

Fasern, die wie bisher mit thermischer Energie, z. B. Lichtbogen, miteinander verspleißt wurden, mußten nach dem Spleißen mit einer mechanischen Vorrichtung gegen Bruch gesichert werden.

Bei Anordnungen, in denen eine Komponente gelötet wird, schließt der Lotschmelzpunkt von 120 bis 250°C eine Hochtemperaturanwendung, z. B. für Sensoren, aus.

Bei Lasern, Modulatoren und anderen elektrooptischen Komponenten wurde in bisherigen Anordnungen der Draht für den elektrischen Anschluß, z. B. die Pumpstromzuführung, gebondet. Hierfür war ein Extrawerkzeug (Bondmaschine) erforderlich.

Aufgabe der Erfindung ist es, eine optische und elektrische Verbindung von elektrooptischen Komponenten zu schaffen, die kostengünstig realisierbar sowie langzeit- und temperaturstabil ist, um in wirtschaftlich vertretbarer Weise informationsübeitragendes Licht aus einem oder mehreren Wellenleitern der einen Komponente in einen oder mehrere Wellenleiter der anderen Komponente einkoppeln zu können.

Was den verfahrenstechnischen Teil der Erfindung betrifft, so soll für eine derartige Verbindung eine kostengünstige, langzeit- und temperaturstabile Ausrichtungs- und Befestigungstechnologie zur Verfügung gestellt werden.

Gemäß der Erfindung wird die Aufgabe hinsichtlich des gegenständlichen Teils bei einer Verbindung der eingangs bezeichneten Art dadurch gelöst, daß die beiden Komponenten ohne Verwendung von Hilfsträgern unmittelbar auf nur einer einzigen, gemeinsamen Trägerplatte durch Schweißen mit elektromagnetischer Strahlung im Wellenlängenbereich um 1 µm befestigt sind.

Alternativlösungen des verfahrensmäßigen Teils der gestellten Aufgabe offenbaren die Ansprüche 11 und 12.

Unter elektrooptischen Komponenten im Sinne der vorliegenden Erfindung werden Strukturen mit optischen Wellenleitern verstanden, die im Bereich der Koppelstelle im wesentlichen parallel zur zugeordneten Auflagefläche auf der Trägerplatte ausgerichtet sind. Als Beispiele werden genannt:
- Quaderförmige integriert-optische oder integriert-elektrooptische Chips aus InP, GaAs, PbS, Tantalat, Glas, Germanium oder Silizium, z. B. Halbleiterlaser, Halbleiterdetektoren, Splitter, Richtkoppler, Schalter, Modulatoren, Multiplexer und Demultiplexer, Flachspektrographen.
- Zylindrische Strukturen wie Fasern aus Glas.

Was die erfindungsgemäß anzuwendende elektromagnetische Strahlung anbelangt, so kann -beispielsweise - eine solche Strahlung aus Nd-Glas- oder Nd-YAG-Lasern mit einer Ausgangswellenlänge im Bereich um λ = 1 µm eingesetzt werden. Andere Quellen ähnlicher Strahlungseigenschaften im Wellenlängenbereich von λ = 0,2 µm bis λ=2,0 µm sind möglich.

Ein wesentlicher Vorteil der Erfindung besteht darin, daß nur ein einziges, einfach strukturiertes Befestigungselement, nämlich die Trägerplatte, zum Einsatz kommt, auf der alle elektrooptischen Komponenten sowie (eventuell) eine optische Abbildungsanordnung, z. B. Kugellinse, direkt, d. h. ohne Zwischen- oder Extraträger, mit einem einzigen Verfahren, nämlich dem Schweißen mit elektromagnetischer Strahlung, befestigt werden.

Ausgestaltungen der Erfindung hinsichtlich ihres gegenständlichen Teils können den Ansprüchen 2 bis 9 entnommen werden.

Vorteilhafte Weiterbildungen des verfahrensmäßigen Teils der Erfindung gehen aus den Ansprüchen 13 bis 16 hervor.

In der Zeichnung sind Ausführungsbeispiele der Erfindung dargestellt, die im folgenden beschrieben werden. Es zeigt (jeweils in starker Vergrößerung):
- Fig. 1: - im Vertikalschnitt - eine Ausführungsform einer optischen und/oder elektrooptischen Verbindung unter Verwendung einer ebenen Trägerplatte,
- Fig. 2: eine gegenüber Fig. 1 etwas abgewandelte Variante einer Verbindung zweier Fasern, in Schnittdarstellung entsprechend Fig. 1,
- Fig. 3: eine andere Ausführungsform einer Verbindung, bei der die Komponenten auf einer abgestuften Trägerplatte angeordnet sind, in Schnittdarstellung entsprechend Fig. 1 und 2,
- Fig. 4: eine weitere Ausführungsform einer Verbindung, unter Verwendung einer zweifach abgestuften Trägerplatte und einer Kugellinse, in Schnittdarstellung entsprechend Fig. 1 bis 3,
- Fig. 4a: - in Schnittdarstellung entsprechend Fig. 4 - eine weitere Variante einer Verbindung, bei der eine spezielle Linse zur Anwendung kommt, jedoch - im Unterschied zu Fig.4 - mit ebener Trägerplatte,
- Fig. 5: - in Vorderansicht - die Befestigung eines Halbleiterlasers auf einer Trägerplatte,
- Fig. 6: - in Draufsicht - die Befestigung eines Halbleiterlasers mit laseraktiver Zone auf einer Trägerplatte, und
- Fig. 7: in Schnittdarstellung entsprechend Fig. 1 bis 4 - die Befestigung eines Pumpstromzuführungsdrahtes an einem Halbleiterlaser.

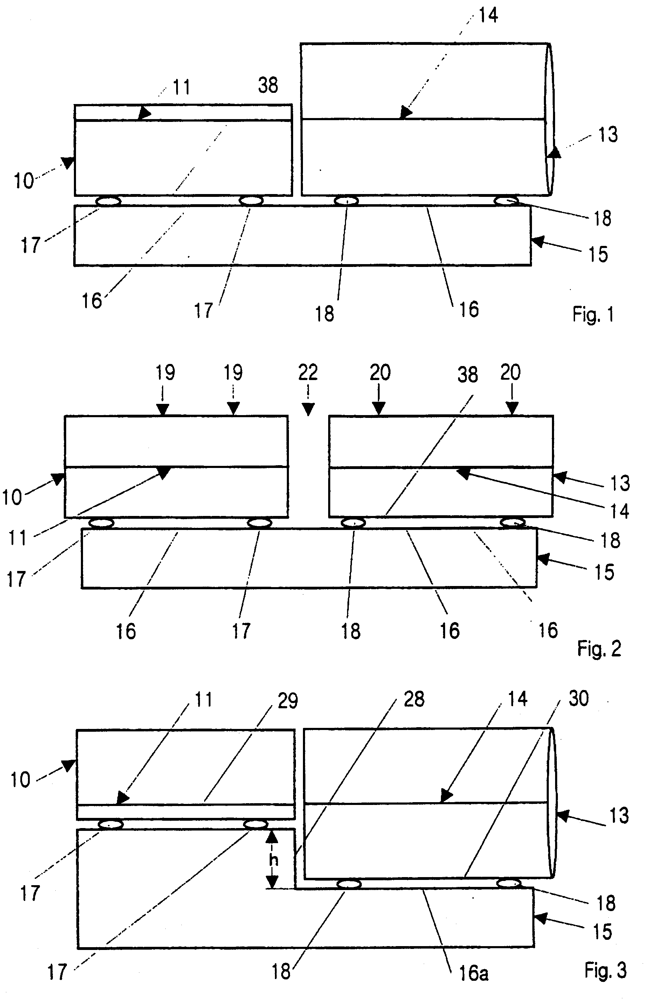

In Fig. 1 bezeichnet 10 eine einen Wellenleiter 11 aufweisende erste elektrooptische Komponente, z. B. einen Halbleiterlaser. Mit 13 insgesamt ist eine mit der ersten Komponente 10 zusammenwirkende zweite Komponente, z. B. eine Faser, beziffert, die einen Wellenleiter 14 aufweist. Mit 15 ist eine Trägerplatte bezeichnet, auf der und mit deren Hilfe die Wellenleiter 11 und 14 der Komponenten 10 und 13 verbunden werden. Hierzu besitzen die beiden Komponenten 10 und 13 jeweils eine Auflagefläche 16. Schmelzstellen 17 bzw. 18 kennzeichnen die Verbindungsstellen der ersten Komponente 10 bzw. der zweiten Komponente 13 mit der Trägerplatte 15.

Durch Pfeile 19 bzw. 20 ist in Fig. 2 eine zur Herstellung der Schweißverbindungen (bei 17, 18) verwendete elektromagnetische Strahlung angedeutet, die sich im Wellenlängenbereich um 1 µm (vorzugsweise 1,06 µm) bewegt.

Ist eine der beiden Komponenten, z. B. die erste Komponente 10 in Fig. 1, oder beide Komponenten 10, 13 in Fig. 2, für die elektromagnetische Strahlung 19 bzw. 19, 20 transparent, so kann diese durch die betreffende Komponente 10 und/oder 13 selbst zugeführt werden. Die Strahlung darf aber hierbei die elektrooptischen Komponenten 10 bzw. 10, 13 nicht in ihrer elektrooptischen Funktion beeinträchtigen.

Bei der Herstellung der in Rede stehenden Schweißverbindung sind ferner die Abbildungseigenschaften der Komponenten 10 und/oder 13 für die Strahlung 19 und/oder 20 zu berücksichtigen. Sind die Komponenten als Fasern ausgebildet (z. B. Komponente 13 in Fig. 1 oder Komponenten 10, 13 in Fig. 2), so wirken die Fasern jeweils als eine Zylinderlinse, die linienförmige Schmelzzonen (z. B. 18) entstehen läßt.

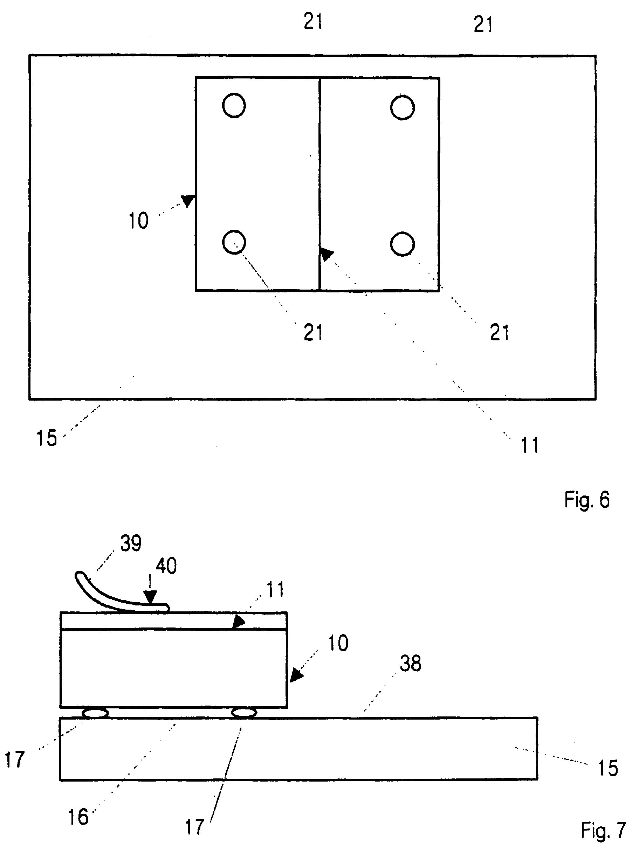

Wenn dagegen für die Komponenten 10, 13 Material verwendet wird, das für die Strahlung 19, 20 nicht transparent ist, so können diese Komponenten auf der Trägerplatte 15 befestigt werden, indem die Strahlung 19, 20 jeweils ein Loch (in Fig. 6 mit 21 bezeichnet) in die Komponenten 10, 13 schmilzt und so an die Grenzflächen 16 der Komponenten 10, 13 zur Trägerplatte 15 gelangt. Ist eine der Komponenten 10 oder 13 als Halbleiterlaser ausgebildet, so müssen die Löcher 21 neben der laseraktiven Zone 11, 14 geschmolzen werden, um die Funktion als Laser nicht zu beeinträchtigen (Fig. 1 und 6). In Fig. 6 kennzeichnet 11 die laseraktive Zone der Komponente 10. Die Schmelzstellen 17 zur Befestigung der Komponente 10 auf der Trägerplatte 15 sind unterhalb der Löcher 21 zu finden.

Wenn beide Komponenten 10, 13 - wie bei der Ausführungsform nach Fig. 2 - als Fasern ausgebildet sind und miteinander verspleißt werden sollen, muß hierfür die elektromagnetische Strahlung in Pfeilrichtung 22 (Fig. 2) zugeführt werden.

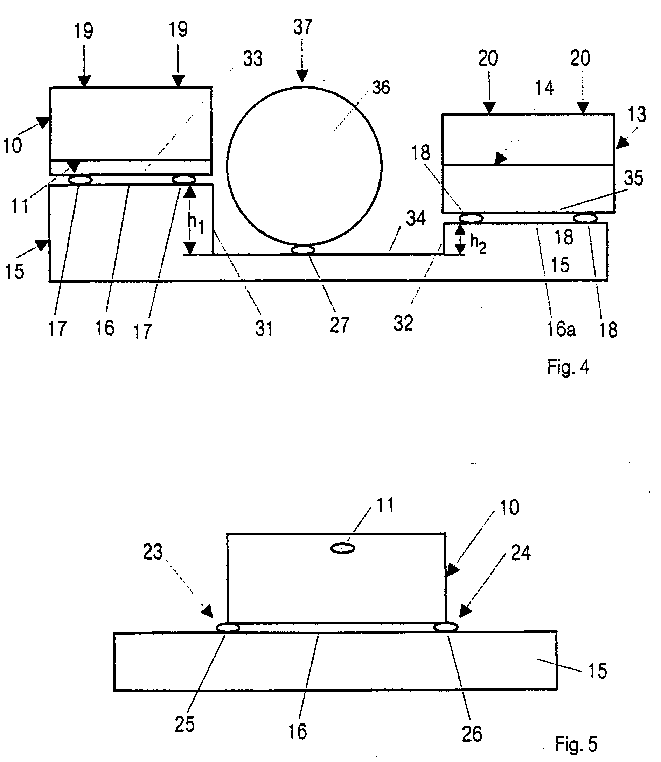

Um eine Komponente, z. B. die erste Komponente 10, auf der Trägerplatte 15 zu befestigen, kann - alternativ zu der aus Fig. 1 und 2 ersichtlichen Strahlungszuführung - die elektromagnetische Strahlung auch schräg seitlich zugeführt werden. Diese Verfahrensvariante ist aus Fig. 5 ersichtlich. Die elektromagnetische Strahlung ist hier durch Pfeile 23, 24 angedeutet, und die Verbindungsstellen (Schweißstellen) sind mit 25, 26 beziffert.

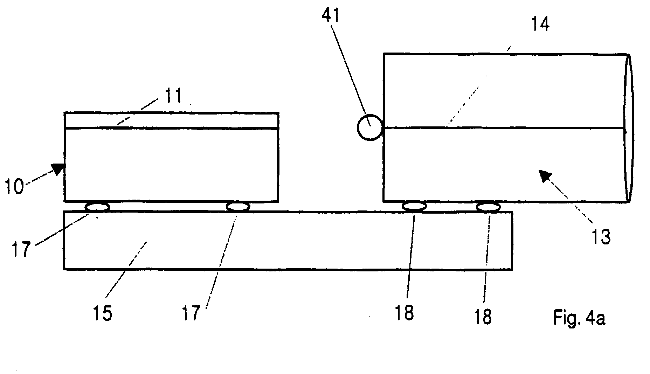

Bei der Ausführungsform nach Fig.3 ist die Trägerplatte 15 - im Unterschied zu Fig. 1, 2 und 6 - abgestuft ausgebildet (bei 28). Hierdurch ergeben sich zwei Ebenen 29, 30 unterschiedlichen Niveaus. Entsprechend parallel und unterschiedlich nivelliert sind die mit dei Trägerplatte 15 zusammenwirkenden Auflageflächen 16 und 16a der Komponenten 10 bzw. 13. Im übrigen sind in Fig. 3 die den Ausführungsformen nach Fig. 1 und 2 entsprechenden Teile mit denselben Bezugszeichen wie dort versehen. Auch bei der Ausführung nach Fig. 4 ist die Trägerplatte 15 abgestuft ausgebildet. Sie besitzt aber - im Unterschied zu Fig. 3 - zwei Stufen, die mit 31 und 32 beziffert sind. Hieraus resultieren drei Parallelebenen 33, 34, 35 unterschiedlichen Höhenniveaus der Trägerplatte 15. Die beiden äußeren Trägerplattenebenen 33, 35 kooperieren mit den zugeordneten Auflageflächen 16 bzw. 16a der beiden Komponenten 10 bzw. 13.

Eine weitere Besonderheit der Ausführungsform nach Fig. 4 besteht darin, daß auf der dritten (mittleren) Trägerplattenebene 34 eine Linse, z. B.eine Kugellinse 36, angeordnet und befestigt ist. Es handelt sich um eine Abbildungslinse zum Anpassen der Fleckweiten der Wellenleiter 11 und 14 der Komponenten 10 und 13. Die Schmelzstelle zur Befestigung der Kugellinse 36 auf der Trägerplatte 15 (Ebene 34) ist mit 27 bezeichnet.

Entsprechend Fig. 2 deuten auch ist Fig. 4 Pfeile 19, 20 die Eintragrichtungen der elektromagnetischen Strahlung für die Befestigung der Komponente 10 bzw. 13 an. Die Eintragrichtung der elektromagnetischen Strahlung zum Befestigen der Kugellinse 36 ist durch einen Pfeil 37 markiert.

Die Form der Trägerplatte 15 ist bei allen dargestellten Ausführungsformen sehr einfach. Nur diejenigen Flächen der Trägerplatte 15, auf welcher die elektrooptischen Komponenten 10 und 13 sowie - gegebenenfalls - 36 befestigt werden sollen, bedürfen besonderer Aufmerksamkeit. Dagegen können alle übrigen Flächen der Trägerplatte 15 praktisch beliebig gestaltet sein. Haben Wellenleiter 11 der Komponente 10 und Wellenleiter 14 der Komponente 13 gleichen Abstand zur Auflagefläche auf der Trägerplatte 15, wie dies bei den Ausführungsbeispielen nach Fig. 1 und 2 der Fall ist, so genügt es, wenn die Trägerplatte 15 eine einzige ebene Befestigungsfläche (in Fig. 1 und 2 mit 38 beziffert) aufweist.

Fig. 1 zeigt speziell eine typische Laser-Faser-Koppelanordnung. Aber auch die Kopplung eines Lasers an einen Splitter ist möglich, ebenso wie die Kopplung zweier Laser, z. B. als Mehrsektionslaser oder bei Injektion-Locking. Eine weitere Anwendungsmöglichkeit ist die Hintereinanderschaltung von Splittern. So kann aus drei identischen 1-auf2-Splittern ein 1-auf-4-Splitter gefertigt werden. Aber auch die Hintereinanderschaltung von mehreren Mach-Zehnder-Interferometer-Chips zu einem Multiplexer oder Demultiplexer ist möglich.

Die aus Fig. 2 ersichtliche Anordnung einer Verbindung zweier Fasern ermöglicht einen weiterer Vorteil: Die üblicherweise zum Spleißen der beiden Fasern eingesetzte Lichtbogenenergie kann hier durch die Strahlung (Pfeil 22) eines Nd-Glas- oder Nd-YAG-Lasers ersetzt werden, so daß optische und mechanische Verbindungen mit nur einem Werkzeug durchgeführt werden.

Haben Wellenleiter 11 von Komponente 10 und Wellenleiter 14 von Komponente 13 nicht gleichen Abstand zur zugeordneten Auflagefläche auf der Trägerplatte 15 (dies ist bei den Ausführungsformen nach Fig. 3 und 4 der Fall), so muß die Trägerplatte 15 - wie oben beschrieben - entsprechend abgestuft ausgebildet sein, um die Abstandsunterschiede zu den jeweils zugeordneten Auflageflächen (29, 30 in Fig. 3 bzw. 33, 35 in Fig.4) auszugleichen. Die Stufenhöhe h (Fig. 3) bzw. h₁-h₂ (Fig. 4) ist also gleich dem Unterschied der Abstände der Wellenleiter 11 zur Auflagefläche 29 und 14 zur Auflagefläche 30 (Fig. 3) bzw. der Wellenleiter 11 zur Auflagefläche 33 und 14 zur Auflagefläche 35 (Fig.4).

Die bei der Ausführungsform nach Fig. 4 vorgesehene Kugellinse 36 dient zur Anpassung des in den Wellenleitern 11 und 14 geführten Lichtes. Die Kugellinse 36 wird mit elektromagnetischer Strahlung 37 befestigt (bei 27 auf der Fläche 34 der Trägerplatte 15).

Der Einsatz anderer Linsen, wie z. B. Zylinderlinsen, ist ebenfalls möglich. Eine entsprechende vorteilhafte Ausführungsform zeigt Fig. 4a. Hierbei wird, wie bisher bekannt, eine zur Fleckweitenanpassung eingesetzte Zylinderlinse 41 zunächst mit einer der Komponenten 10 oder 13 (hier: 13) verbunden. Erst danach werden erfindungsgemäß die Komponenten 10 und 13 miteinander verbunden. Andere bekannte Ausführungen von Komponenten 10 und/oder 13, bei denen z. B. die Komponente 13 ein linsenförmig ausgebildetes Faserende aufweist, können ebenfalls mit den Maßnahmen der vorliegenden Erfindung verbunden werden.

Die Anordnungen nach Fig. 5 und 6 zeigen speziell einen auf der Trägerplatte 15 befestigten Halbleiterlaser (10, 11). Bei der Variante nach Fig. 5 (Vorderansicht) wird - wie bereits oben ausgeführt - die elektromagnetische Strahlung 23, 24 seitlich zu den Schmelzzonen 25, 26 geführt. Bei der Variante nach Fig. 6 wird die Strahlung direkt von oben (senkrecht zur Zeichenebene) zugeführt und bohrt sich jeweils ein Loch 21, um zu den Schmelzzonen 17 zu gelangen.

Bei der Ausführungsform nach Fig. 7 ist ein Halbleiterlaser 10, der einen Wellenleiter 11 aufweist, mittels Schmelzstellen 17 an einer Trägerplatte 15 mit einer durchgehend ebenflächigen Auflagefläche 38 befestigt. Insoweit entspricht alles der Ausführungsform nach Fig. 1 (siehe dort linke Seite). Die Besonderheit der Variante nach Fig.7 besteht nun darin, daß an dem Halbleiterlaser 10 ein Pumpstromführungsdraht 39 mittels elektromagnetischer Strahlung 40 befestigt ist. Hierbei wird - wie durch einen Pfeil angedeutet - die Strahlung 40 senkrecht von oben zugeführt.

In jedem Fall muß bei allen gezeigten und beschriebenen Ausführungsformen die elektromagnetische Strahlung so zugeführt werden, daß sie in den Zonen 17, 18 (Fig.1 bis 4 und 7), 25, 26 (Fig. 5), 27 (Fig. 4) und 21 (Fig. 6) das Material der Fügepartner 10 und 15 bzw. 13 und 15 bzw. 39 und 10 (Fig. 7) bzw. 39 und 13 (nicht gezeigt) bzw. 36 und 15 (Fig. 4) zum Schmelzen bringt, so daß sich nach dem Abkühlen eine stoffschlüssige Verbindung zwischen den Fügepartnern ergibt.

Als Material für die Trägerplatte 15 kommen alle mit elektromagnetischer Strahlung schweißbaren Materialien in Frage, insbesondere Metalle, vorzugsweise Kupfer und Kovar, aber auch Silizium oder Glas. Die Eignung dieser Materialien für den Zweck der vorliegenden Erfindung wurde anhand von Versuchen nachgewiesen.

Die Zuführung der Strahlung 19 durch die Komponente 10 (Fig. 1 und 2) ermöglicht folgende Vorgehensweise: Die Komponente 10 wird mit einer (nicht gezeigten) Hilfsvorrichtung, z. B. einem Präzisionsmanipulator oder einem präzisen XY-Translationstisch, gefaßt, mit ihrer Auflagefläche 16 auf die Trägerplatte 15 aufgesetzt und mit der Hilfsvorrichtung in ihre Endposition verschoben. Dann wird sie in dieser Position durch Einschalten der Strahlung 19 befestigt.

Die Befestigung der Komponente 13 kann in gleicher Weise erfolgen, wobei wahlweise die Informationsstrahlung aus dem Wellenleiter 11 der Komponente 10 zur Positionsfindung der Komponente 13 eingesetzt werden kann (aktive Justierung). Alternativ hierzu läßt sich die gesuchte Position der Komponente 13 auch durch die äußeren Formen der Komponenten 10 und 13 oder mit Hilfsmarkierungen (nicht gezeigt) finden, ohne daß Informationsstrahlung von der Komponente 10 oder der Komponente 13 abgegeben wird (passive Justierung). In beiden Fällen ist eine Ausrichtung nur in zwei Koordinatenrichtungen erforderlich, da die dritte Koordinate durch die Oberfläche 38 bzw. 29, 30 bzw. 33, 34, 35 der Trägerplatte 15 bestimmt wird. Wenn eine der Komponenten 10 oder 13 ein Laser ist, kann die zum Befestigen eingesetzte elektromagnetische Strahlung (54) auch benutzt werden, um den Draht 39 zum Zuführen des Pumpstromes auf dem Laser zu befestigen (siehe Fig. 7 und obige Ausführungen hierzu).

Vorteilhaft ist das Schweißen im Vakuum, weil im Vakuum die durch die elektromagnetische Strahlung eingebrachte Wärme langsamer abgeführt wird und dadurch nur kleinere Strahlungsleistungen notwendig sind, und weil ev. im Schweißplasma entstehende Gase aus den Materialien der Fügepartner im Vakuum schneller und weiter wegdiffundieren als in Luft. Auf diese Weise läßt sich eine mögliche Beeinträchtigung der Fügepartner (10, 15 bzw. 13, 15 bzw. 36, 15 bzw. 39, 10), etwa durch Absetzen der entstehenden Gase auf der Spiegelfläche eines Lasers, erheblich reduzieren.

Zusammenfassend lassen sich durch die Erfindung folgende vorteilhafte Wirkungen erzielen:
- Einfach strukturierte und kostengünstige Trägerplatte 15: nur eine ebene Auflagefläche (38 bzw. 29, 30 bzw. 33 bis 35), evtl. mit Stufe (28 bzw. 31, 32) erforderlich. Keine Befestigungsnuten auf der Trägerplatte 15 notwendig. Außer der Trägerplatte 15 wird kein weiteres Befestigungselement benötigt. Voraussetzung: die Abstände der Wellenleiter 11 und 14 von den zugehörigen Auflageflächen zur Trägerplatte 15 sind hinreichend genau bekannt.
- Die Fügepartner (10, 13, 36) werden direkt auf die Trägerplatte 15 montiert, keine Addition von Montagefehlern.
- Ausrichtung nur in zwei Koordinatenrichtungen erforderlich, dadurch sehr variable Plazierung der Komponenten (10, 13) möglich.
- Kompakter Aufbau (Modulgröße für Laser-Faser-Kopplung ohne Gehäuse < 1 mm³).
- Geringer Verzug beim Befestigen, da die Volumina der geschmolzenen Materialien sehr klein gehalten werden können.
- Einfache und kostengünstige Befestigung aller zu verbindenden Teile (Nd-Glas-Laser werden schon für 10 000 DM angeboten).
- Kein Löt-, Klebe- und Bondwerkzeug erforderlich.
- Hohe Lebensdauer (kein Kleber oder Lot erforderlich).
- Einsatz bei hohen Temperaturen möglich (bei Testversuchen gab ein InP-Laser noch bei 250°C Licht ab, bis 400°C scheinen möglich).
- Vielseitige Verwendung (z. B. Laser-Faser-Kopplung, Ersatz für mechanischen oder thermischen Spleiß, Hintereinanderschaltung von Splittern oder Mach-Zehnder-Interferometer-Chips).

## Patentansprüche

1. Optische und/oder elektrische Verbindung von jeweils zwei optischen und/oder elektrooptischen Komponenten (10, 13, 39) jeweils bestehend aus Strukturen mit optischen Wellenleitern (11, 14), die im Bereich der Verbindungsstelle (17, 18, 25, 26) parallel oder im wesentlichen parallel zur Auflagefläche (38, 29, 30, 33, 35) auf einer Trägerplatte (15) angeordnet sind,
dadurch gekennzeichnet, daß die beiden Komponenten (10, 13) ohne Verwendung von Hilfsträgern unmittelbar auf nur einer einzigen, gemeinsamen Trägerplatte (15) durch Schweißen mit elektromagnetischer Strahlung (19, 20, 23, 24, 40) im Wellenlängenbereich von 0,2 µm bis 2,0 µm befestigt sind.

2. Verbindung nach Anspruch 1,
dadurch gekennzeichnet, daß die Trägerplatte (15) eine ebene Auflagefläche (38) aufweist und die optischen und/oder elektrooptischen Komponenten (10, 13) auf der ebenen Auflagefläche (38) angeordnet und befestigt sind (Fig. 1, 2, 5 und 7).

3. Verbindung nach Anspruch 1,
dadurch gekennzeichnet, daß die Trägerplatte (15) zwei zueinander parallele abgestufte Auflageflächen (29, 30) aufweist, auf denen je eine der beiden Komponenten (10, 13) angeordnet und befestigt ist (Fig. 3).

4. Verbindung nach Anspruch 1, 2 oder 3,
dadurch gekennzeichnet, daß als eine (10) der beiden Komponenten (10, 13) ein Halbleiterlaser dient, der auf der Trägerplatte (15) durch Winkeleintrag der elektromagnetischen Strahlung (23, 24) befestigt ist (Fig. 5).

5. Verbindung nach Anspruch 1, 2 oder 3,
dadurch gekennzeichnet, daß eine (10) der beiden Komponenten (10, 13) eine elektrooptische Komponente ist, die einen mit elektromagnetischer Strahlung (40) befestigten Stromzuführungsdraht (39) besitzt (Fig. 7).

6. Verbindung nach Anspruch 1, 2 oder 3,
dadurch gekennzeichnet, daß als eine (13) der beiden Komponenten (10, 13) eine Faser (13) dient, die auf der Trägerplatte (15) - unter Ausnutzung ihrer Zylinderlinsenwirkung auf die elektromagnetische Strahlung (20) - befestigt ist (Fig. 1 und 3).

7. Verbindung nach einem oder mehreren der Ansprüche 1 bis 3 und 6,
dadurch gekennzeichnet, daß beide elektrooptische Komponenten (10, 13) Fasern sind, die durch die elektromagnetische Strahlung (19, 20) nicht nur auf der Trägerplatte (15) befestigt, sondern auch miteinander verspleißt sind (Fig. 2).

8. Verbindung nach einem oder mehreren der Ansprüche 1 bis 3 und 6,
dadurch gekennzeichnet, daß eine (10) der elektrooptischen Komponenten (10, 13) ein Halbleiterlaser und die andere (13) eine Faser ist.

9. Verbindung nach einem oder mehreren der vorstehenden Ansprüche, wobei zwischen den beider Komponenten (10, 13) - zur Verbesserung der optischen Übertragungseigenschaften - ein optisches Abbildungselement (36) eingefügt ist,
dadurch gekennzeichnet, daß auch das Abbildungselement (36) durch die elektromagnetische Strahlung (37) auf der Trägerplatte (15) befestigt ist und daß auf der Trägerplatte (15) - gegebenenfalls - eine (weitere) gegenüber der (den) zur Befestigung der Komponenten (10, 13) dienenden Trägerplattenebene(n) (33, 35) abgestufte Trägerplattenebene (34) zur Befestigung des Abbildungselements (36) vorgesehen ist (Fig. 4).

10. Verbindung nach Anspruch 9,
dadurch gekennzeichnet, daß das optische Abbildungselement eine Kugellinse (36) ist (Fig. 4).

11. Verfahren zur Herstellung einer Verbindung nach einem oder mehreren der vorstehenden Ansprüche, wobei mindestens eine der zu befestigenden Komponenten (10, 13) aus transparentem Material besteht,
dadurch gekennzeichnet, daß die elektromagnetische Strahlung (19, 20, 40) so gewählt und auf das Material der auf der Trägerplatte (15) zu befestigenden Komponenten (10, 13) abgestimmt wird, daß sie auf ihrem Weg zur Schweißstelle (18) die Komponenten (10, 13) durchdringt, ohne sie in ihrer Funktion zu verändern.

12. Verfahren zur Herstellung einer Verbindung nach einem oder mehreren der Ansprüche 1 bis 10, wobei die zu verbindenden Komponenten (10, 13) aus nicht transparentem Material bestehen,
dadurch gekennzeichnet, daß die elektromagnetische Strahlung (19, 20, 40) so gewählt und auf das Material der auf der Trägerplatte (15) zu befestigenden Komponenten (10, 13) abgestimmt wird, daß sie auf ihrem Weg zur Schweißstelle (17) die Komponenten (10, 13) unter Bildung von Löchern (31) durchdringt, ohne sie in ihrer Funktion zu verändern (Fig. 6).

13. Verfahren nach Anspruch 11 oder 12,
dadurch gekennzeichnet, daß alle zur Befestigung der beiden elektrooptischen Komponenten (10, 13) erforderlichen Fügeschritte im Vakuum durchgeführt werden.

14. Verfahren nach Anspruch 11, 12 oder 13,
dadurch gekennzeichnet, daß die erste Komponente (10) mittels einer Hilfsvorrichtung, vorzugsweise einem Präzisionsmanipulator oder einem präzisen xy-Translationstisch, gefaßt und mit ihrer Auflagefläche (16) auf die Trägerplatte (15) aufgesetzt wird und daß sie anschließend mittels der Hilfsvorrichtung in ihre Endposition auf der Trägerplatte (15) verschoben wird.

15. Verfahren nach einem oder mehreren der Ansprüche 11 bis 13 und nach Anspruch 14,
dadurch gekennzeichnet, daß die zweite Komponente (13) mittels einer Hilfsvorrichtung, vorzugsweise einem Präzisionsmanipulator oder einem präzisen xy-Translationstisch, gefaßt und mit ihrer Auflagefläche (16) auf die Trägerplatte (15) aufgesetzt wird und daß zur Positionsfindung (Endposition) der zweiten Komponente (13) auf der Trägerplatte (15) die Informationsstrahlung aus dem Wellenleiter (11) der ersten Komponente (10) verwendet wird (sogenannte aktive Justierung).

16. Verfahren nach einem oder mehreren der Ansprüche 11 bis 13 und nach Anspruch 14,
dadurch gekennzeichnet, daß die zweite Komponente (13) mittels einer Hilfsvorrichtung, vorzugsweise einem Präzisionsmanipulator oder einem präzisen xy-Translationstisch, gefaßt und mit ihrer Auflagefläche (16) auf die Trägerplatte (15) aufgesetzt wird und daß zur Findung der Endposition der zweiten Komponente (13) auf der Trägerplatte (15) die äußeren Formen der Komponenten (10, 13) oder Hilfsmarkierungen dienen (sogenannte passive Justierung).
